# EUROPEAN PATENT SPECIFICATION

(11) **EP 3 232 480 B1**
(45) Date of publication and mention of the grant of the patent: **18.09.2019**
(21) Application number: 16165293.8
(22) Date of filing: 14.04.2016
(51) Int. Cl.: H01L 29/88, H01L 29/06, H01L 29/16, H01L 31/028, H01L 31/062, H01L 31/09, H01L 21/329

(54) **A METAL-INSULATOR-GRAPHENE TUNNEL DIODE WITH BIAS-INDUCED BARRIER MODULATION**
METALL-INSULATOR-GRAPHEN TUNNELDIODE MIT VORSPANNUNGSINDUZIERTER BARRIERENMODULATION
DIODE MÉTAL-ISOLANT-GRAPHÈNE AVEC MODULATION DE BARRIÈRE INDUITE PAR UNE POLARISATION

(43) Date of publication of application: 18.10.2017
(73) Proprietor: Max-Planck-Gesellschaft zur Förderung der Wissenschaften e.V., 80539 München (DE)
(72) Inventor: Kern, Klaus, 71111 Waldenbuch (DE); Burghard, Marko, 71263 Weil der Stadt (DE); Duong, Dinh Loc, 70563 Stuttgart (DE); Urcuyo, Robert, 70569 Stuttgart (DE)
(74) Representative: Hannke, Christian

(56) References cited:
- US-A1- 2013 162 333
- US-A1- 2015 014 630
- US-A1- 2016 041 335
- US-B2- 8 735 271
- CHAVES FERNEY A ET AL: "Physical model of the contact resistivity of metal-graphene junctions", JOURNAL OF APPLIED PHYSICS, AMERICAN INSTITUTE OF PHYSICS, US, vol. 115, no. 16, 28 April 2014 (2014-04-28), XP012185064, ISSN: 0021-8979, DOI: 10.1063/1.4874181 [retrieved on 1901-01-01]
- ZIXU ZHU ET AL: "Paper;Graphene geometric diodes for terahertz rectennas;Graphene geometric diodes for terahertz rectennas", JOURNAL OF PHYSICS D: APPLIED PHYSICS, INSTITUTE OF PHYSICS PUBLISHING LTD, GB, vol. 46, no. 18, 15 April 2013 (2013-04-15), page 185101, XP020243858, ISSN: 0022-3727, DOI: 10.1088/0022-3727/46/18/185101
- ROBERTO URCUYO ET AL: "High Performance Graphene-Oxide-Metal Diode through Bias-Induced Barrier Height Modulation", ADVANCED ELECTRONIC MATERIALS, vol. 2, no. 9, 1 September 2016 (2016-09-01), page 1600223, XP055309138, ISSN: 2199-160X, DOI: 10.1002/aelm.201600223
- Chris M. Corbet ET AL: "Oxidized Titanium as a Gate Dielectric for Graphene Field Effect Transistors and Its Tunneling Mechanisms", ACS Nano, vol. 8, no. 10, 28 October 2014 (2014-10-28), pages 10480-10485, XP055497189, US ISSN: 1936-0851, DOI: 10.1021/nn5038509

## Description

The invention relates to an electronic device comprising:
- a first electrically conductive layer provided with a first work function,
- a second electrically conductive layer provided with a second work function,
- an insulating layer arranged between said first electrically conductive layer and said second electrically conductive layer,
wherein a tunneling barrier is formed between said first and second electrically conductive layers and a barrier-height of the tunneling barrier depends on said first and second work functions.

In case the two electrically conductive layers consist of a metal, such devices are called metal-insulator-metal (MIM) diodes. MIM-diodes are promising for application in high frequency mixers, photo detectors and in rectenna devices for solar energy harvesting.

Conventional semiconductor-based solar cells are based on the principle of electron-hole generation due to incident photons. Such devices are limited in their efficiency since electrons excited far above the bandgap thermally relax to the conduction band edge resulting in an energy loss. Complementary to using the particle-nature of the photon, the wave-nature may also be used in antenna-coupled diode solar cells. The wave-nature of the photon may be used if photon energy is concentrated on a device that is smaller than the photon wavelength and that responds fast enough to the oscillations of the photon field. The photon energies are collected by antenna devices provided with a rectifying element.

The ability of a diode to process such optical frequencies is limited to its time constant. The inverse of this time constant constitutes an upper limit for the responsiveness of a diode. Diodes are mainly based on semiconductors, for example p-n diodes which use the potential barrier at the p-n junction, Schottky-diodes which exploit the Schottky barrier between a metal and a semiconductor and Esaki diodes which use interband-tunneling at the p-n junction. Since tunneling transport happens typically faster than electron/hole transport, diodes based on tunneling have a smaller time constant. Semiconductor-based diodes have, however, the disadvantage that they exhibit comparatively low plasma frequencies. Thus, MIM-diodes (metal-insulator-metal) show the smallest time constant.

A MIM-diode comprises two metal layers which are separated by an oxide layer. The thickness of the oxide layer is designed such that tunneling carrier transport between the two metal layers is possible. The properties of such a device are characterized by their band structure. The shape of the band structure, in particular the shape of the tunnel barrier is determined by the work functions of the two metal layers, the electron affinity of the insulator, the band gap of the insulator and the valence- and conduction-band-offsets.

In order to achieve a small time constant of the device, the tunneling transport should dominate in the device. To make the tunneling the dominant transport mechanism, typically the insulting layer needs to exhibit an appropriate thickness. Such a tunneling dominated device shows, however, the disadvantage of a small asymmetry in the I-V curve, due to the fact that a tunneling current makes a significant contribution at a reverse bias. Efficient rectifying requires, however, a high asymmetry.

A good MIM diode performance requires a high asymmetry (f*_{ASYM}*= I*_{forward}*/I*ᵣₑᵥₑᵣₛₑ*)*,* a strong nonlinearity (f*_{NL}*=(dI/dV) / (I/V)), which determines how abruptly the diode turns on, a large responsivity (f*_{RES}*=(d²I/d²V)/(dI/dV)) as well as a low resistance or a high on-current. These figures of merit are mainly determined by the difference in work function (WF) of the metal layers and the barrier height between the insulator and the metal layers. In the design of MIM diodes, a trade-off between these parameters is needed. For instance, a high asymmetry requires both, a large difference in work function between the two metal layers and a large barrier height, but a too high barrier decreases the on-current or increases the resistance of the device.

Among the various investigated metal/insulator/metal configurations, the best overall performance has been attained for Nb/Nb₂O₅/Pt diodes, featuring an asymmetry of 7800 and a nonlinearity of 4 at 0.5 V.

A further drawback of MIM diodes is that the metal surfaces exhibit a rather high roughness that is in the order of the thickness of the oxide. The roughness of the metallic surfaces results in a non-uniform electric field and therefore in a non-uniform tunneling current.

Different devices wherein tunneling transport between graphene as a layer material and a metal electrode are disclosed for example in US 2013/162333 A1, US 2015/014630 A1, US 2016/041335 A1, US 8 735 271 B2 and Chris M. Corbet et al, ACS Nano, 2014, vol. 8, no. 10, pages 10480-10485 (DOI: 10.1021/nn5038509).

In particular, US 2013/162333 A1 discloses a MIM diode comprising a graphene layer as a first electrode, a dielectric layer and a metal layer as second electrode. The dielectric layer can be made of Al₂O₃, HfO₂, BN or DLC. US 2015/0014630 A1 discloses a tunneling diode comprising a dielectric layer sandwiched between two layers of 2D materials, for example p- or n-doped graphene. US 2016/041335 A1 discloses a rectenna comprising a dielectric layer sandwiched between two different metal layers. A graphene layer can be formed between the dielectric layer and the top metal layer to improve the asymmetry of the I-V characteristic. US 8 735 271 B2 discloses a gate tunable tunnel diode comprising a dielectric layer sandwiched between a graphene layer and a metal layer. The graphene work function can be modulated by means of a voltage applied to a gate electrode separated from the graphene layer by means of a gate dielectric layer.

Object of the invention is therefore to provide an electronic device that overcomes the above-mentioned disadvantages.

The problem is addressed by an electronic device comprising:
- a first electrically conductive layer provided with a first work function,
- a second electrically conductive layer provided with a second work function,
- an insulating layer arranged between said first electrically conductive layer and said second electrically conductive layer,
wherein a tunneling barrier is formed between said first and second electrically conductive layers and a barrier-height of the tunneling barrier depends on said first and second work functions. The electronic device is further characterized in that the first electrically conductive layer comprises graphene, wherein the electronic device is a diode and is configured so that a bias applied between the first and the second electrically conductive layer modulates said first work function and therefore said barrier-height of the tunneling barrier, wherein the insulating layer consists of an oxide, the oxide being TiOₓ or ZnO or graphene-oxide in case of electron transport or the oxide being NiO or WO₃ in case of hole transport.

According to the invention the bias applied between the first and the second electrically conductive layers causes a carrier transport between the first and the second electrically conductive layers through said insulating layer. Preferably said carrier transport is modified due to the modulation of the barrier-height of the tunneling barrier.

According to the invention, said carrier transport is electron or hole transport. In embodiments not forming part of the claimed invention, the carrier transport could, however, also be transport of other quasiparticles. Preferably, the carrier transport is dominated by a transport mechanism that is based on a tunneling and/or on thermionic emission. Thermionic emission is the thermally induced flow of charge carriers over the potential-energy barrier. This occurs because the thermal energy given to the carrier overcomes the potential-energy barrier.

According to a preferred embodiment, the first electrically conductive layer consists of monolayer graphene. A first electrically conductive layer comprising monolayer graphene has the advantage that the corresponding first work function may be modulated more extensively. It is, however, equally conceivable that the first electrically conductive layer consists of multilayer graphene.

Preferably the first and the second electrically conductive layers are provided with ohmic contacts which form electrodes for the applied bias. Preferably, the first electrically conductive layer comprising graphene is provided with a Ti/Au contact through standard e-beam lithography. Advantageously, the second electrically conductive layer is grounded and a potential is applied to the first electrically conductive layer. Thus, the electronic device is a two terminal diode in which the first work function and therefore said barrier-height of the tunneling barrier is modulated only by the bias applied at the two terminals.

According to a preferred embodiment the first work function has a larger value than the second work function. In other words, the work function Φ₁ of the graphene layer has a larger value than the work function φ₂ of the material of the second layer. The difference between the work functions leads to a trapezoidal barrier at zero bias.

In a preferred embodiment, the first work function Φ₁ of the graphene layer increases by Δ_{Φ}, in case a positive bias is applied. Hereby it is assumed that the second electrically conductive layer is grounded and the potential is applied to the first electrically conductive layer. The effective barrier height for the current based on thermionic emission, also called thermionic current, depends on the increased first work function minus the applied potential (Φ₁+ Δ_{Φ}- eV). The thermionic current depends on the relative magnitude of eV and Δ_{Φ}. For sufficient thin insulating layers which consist of a material with a very large dielectric constant, the condition eV < Δ_{Φ} may be achieved. In this case, the thermionic current would be fully blocked. In a conventional MIM-diode, the effective barrier height for the thermionic current is given by the first work function minus the applied potential (Φ₁-eV). For high biases, the effective barrier height reaches a minimum of φ₂. Further, the first work function Φ₁ of the graphene layer decreases by Δ_{Φ}, in case a negative bias is applied. Hereby it is also assumed that the second electrically conductive layer is grounded and the potential is applied to the first electrically conductive layer. The effective barrier height for the current based on thermionic emission, also called thermionic current, depends on the increased first work function minus the applied potential (Φ₁- Δ_{Φ}). The electronic device according to the present invention is a two terminal diode which in comparison to the conventional MIM-diode allows a higher thermionic current in forward direction. Forward direction here means that a preferably electron current flows from the ground potential of the second electrically conductive layer to the first electrically conductive layer, comprising graphene. Accordingly, an electron current backward direction would mean an electron current flow from the first electrically conductive layer, comprising graphene, to the second electrically conductive layer and to the ground potential.

Further, due to the bias-induced barrier height reduction, the tunneling current in the electronic device of the present invention exceeds that in the MIM structure, which renders
the former type of electronic device more efficient.

Due to the increase of the thermionic current in forward direction and the reduction of the thermionic current in backward direction in the device of the present invention, a high asymmetry (f*_{ASYM}* = I*_{forward}*/I*ᵣₑᵥₑᵣₛₑ*) and a strong nonlinearity (f*_{NL}*=(dI/dV) / (I/V)) are achieved. Further, a high on-current density consisting of the thermionic current and the tunneling current is achieved. In other words, as a major conceptual advantage over conventional MIM-diodes, the thermionic and tunneling currents are simultaneously enhanced upon negatively biasing the first electrically conductive layer, comprising graphene.

It is advantageous that the second electrically conductive layer consists of a metal. In case the carrier transport is electron transport such a metal could preferably be Ti, Au, Cr, Ag, Ni or an alloy comprising Ti, Au, Cr, Ag. The present invention is not limited to the use of these metals/ alloys. Hereby one needs to consider that the selected metal or alloy preferably has a work function that is smaller than the work function of the first electrically conductive layer, comprising graphene.

The insulating layer consists of an oxide. In case the carrier transport is electron transport, the oxide is TiOₓ, ZnO or graphene-oxide. Preferably the TiOₓ is deposited on the first electrically conductive layer comprising graphene by thermal evaporation of Ti. In several subsequent cycles, Ti is deposited on the first electrically conductive layer with an oxidation step preferably performed under ambient oxidation at the end of each cycle.

Alternatively, it would be conceivable that the insulating layer consists of a native metal oxide. Native metal oxides are oxidized through contact with the ambient air rather than by contact with supplied oxygen. According to the invention, a suitable material for this native oxidation would be Ti.

According to the invention the insulating layer can also consist of ZnO or graphene-oxide. The ZnO is deposited on the first electrically conductive layer comprising graphene by atomic layer deposition (ALD). In order to fabricate an insulating layer consisting of graphene-oxide, a graphene multilayer of the first electrically conductive layer serves as a starting point. The first layers may then be oxidized through oxygen plasma.

In case the carrier transport is hole transport the conductive layer consists preferably of a metal with a high work function such as Pd or Pt. Further, in this case as an insulating layer preferably an oxide layer is chosen which blocks electron transport. According to the invention such oxides are NiO or WO₃.

Advantageously, the electronic device further comprises a substrate on which the first electrically conductive layer is deposited. Such a substrate could consist of Si layer that is coated with a SiO₂ -layer. Preferably, the thickness of the SiO₂-layer is in the range of 200 nm to 500 nm, more preferably the thickness of the SiO₂ is 300 nm. It would also be conceivable that the substrate consists of a flexible material preferably a polymer. According to a preferred embodiment, the first electrically conductive layer comprising graphene is deposited on the substrate. It would be equally conceivable that the second electrically conductive layer is deposited on the substrate. In particular the case where a native oxidized metal is used as insulating layer, it is favorable that the second electrically conductive layer, preferably a metallic layer, is deposited on the substrate. In this case, after the oxidation through contact with ambient air, the first electrically conductive layer comprising graphene is deposited on the oxidized layer.

According to a preferred embodiment, the first electrically conductive layer consists of p-doped graphene. In particular, an electronic device comprising a first electrically conductive layer that consists of a monolayer graphene, a deposition of a metal, for example Ti, causes a n-doping in the graphene monolayer. Such an n-doping is undesirable, since through such n-doping the barrier height is reduced. Through the advantageous usage of p-doped graphene, the n-doping effect might be at least partially compensated. Such a p-doped graphene could be fabricated by vapor deposition of inorganic oxides, for example MoO₃, or inorganic molecules, for example F4-TCNQ. Preferably the graphene layer/s is/are exfoliated from highly oriented pyrolytic graphite (HOPG). It is also conceivable that graphene layer/s is/are grown epitaxially or produced by chemical vapor deposition.

According to a preferred embodiment, the second electrically conductive layer has a thickness in the range of 5 nm to 50 nm. Preferably the conductive layer has a thickness of 25 nm. According to a further preferred embodiment, the insulating layer has a thickness in the range of 1 nm to 15 nm. Preferably the insulating layer has a thickness 6 nm.

Further advantages, aims and properties of the present invention will be described by way of the appended drawings and the following description.

In the drawings:
- Fig. 1: shows schematically the structure of the electronic device;
- Fig. 2: shows the energy band diagram of the electronic device;
- Fig. 3: shows a topographic AFM image of the electronic device;
- Fig. 4: shows the back gate dependence of the normalized resistance of the graphene;
- Fig. 5a: shows a surface potential image of the electronic device;
- Fig. 5b: shows a section profile along the solid line (12) in the surface potential map;
- Fig. 6a: shows the energy band diagram at negative bias;
- Fig. 6b: shows the energy band diagram at zero bias;
- Fig. 6c: shows the energy band diagram at positive bias;
- Fig. 7: shows the I-V characteristics and the dependence of the channel resistance on the bias;
- Fig. 8: shows the dependence of the asymmetry (f*_{ASYM})* and nonlinearity (f*_{NL}*) on the bias;
- Figs. 9a - 9d: show the electrical characteristics of the electronic device in dependence of the thickness of the graphene layer;
- Figs. 10a, b: show the effect of temperature on the performance of the electronic device.

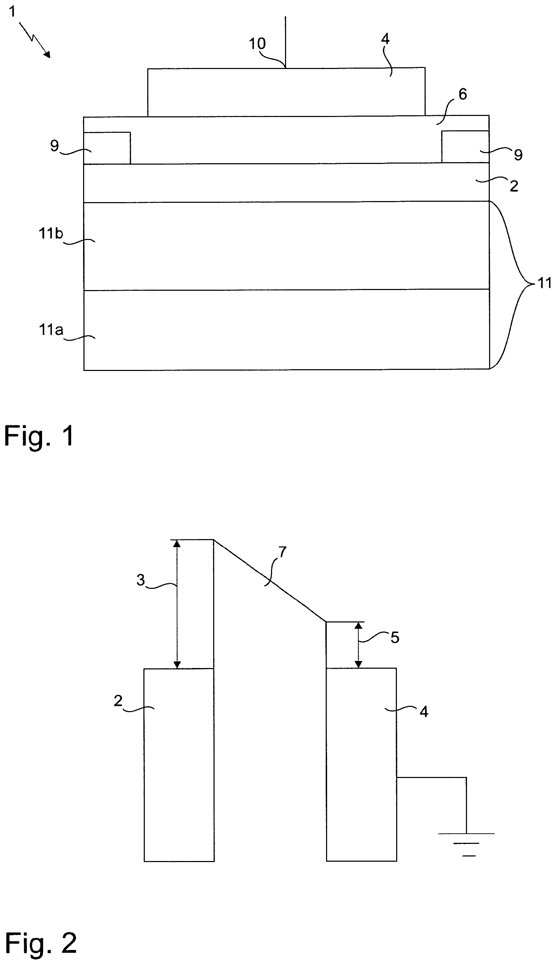

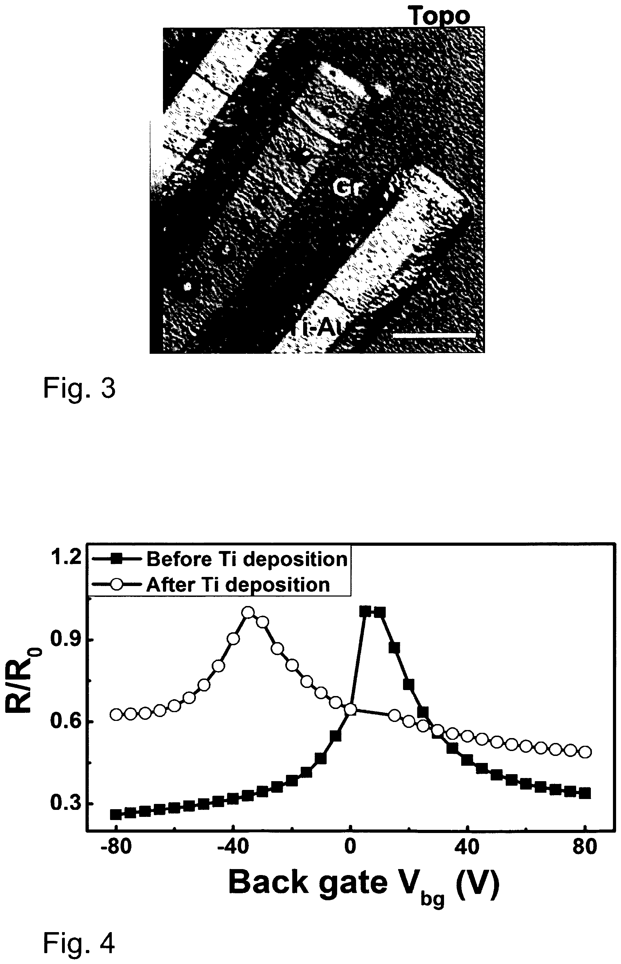

In Fig.1 schematically the structure of an electronic device (1) is displayed. The electronic device (1) comprises a first electrically conductive layer (2) provided with a first work function (3), a second electrically conductive layer (4) provided with a second work function (5) and an insulating layer (6) arranged between said first electrically conductive layer (2) and said second electrically conductive layer (4). Between the first (2) and second electrically conductive layers (4) a tunneling barrier (7) is formed, wherein a barrier-height (8) of the tunneling barrier (6) depends on said first (3) and second work functions (5). The first electrically conductive layer (2) comprises graphene, wherein a bias applied between the first (2) and the second electrically conductive layer (4) modulates said first work function (3) and therefore said barrier-height (8) of the tunneling barrier (7). A topographic AFM image of the structure is displayed in fig. 3.

The first electrically conductive layer (2) may consist of a monolayer graphene or a multilayer. The first (2) and the second electrically conductive layers (4) are provided with ohmic contacts which form electrodes (9, 10) for the applied bias, wherein the second electrically conductive layer (4) is grounded and a potential is applied to the first electrically conductive layer (2).

The graphene bottom electrode was mechanically exfoliated from highly oriented pyrolytic graphite (HOPG) onto a substrate (11). The substrate (11) consists of a Si-layer (11a) and a 300 nm thick SiO₂ layer (11b). The graphene layer was then provided with the ohmic contacts, consisting of Ti/Au through standard e-beam lithography followed by thermal evaporation of the metals. Subsequently, 6 nm of TiOₓ which form the insulating layer (6) were deposited by three subsequent cycles of thermal evaporation of 2 nm Ti, with an oxidation step performed under ambient oxidation at the end of each cycle. Finally, 25 nm thick Ti top electrodes, forming the second electrically conductive layer (4), were defined on top of the TiOₓ insulator via standard e-beam lithography. The first (2) and second electrically conductive layer (4) both contact the insulating layer. Thus, a GrIM-diode (Gr-TiOₓ-Ti diode) (1) with a graphene layer (2) and a metal layer (4), wherein the graphene layer (2) and the metal layer (4) are separated by an insulating layer (6), is formed.

In fig. 2 the energy band diagram of the electronic device (1) is shown. The energy band diagram is determined by the first work function (3) of the graphene layer (2), the second work function (5) of the metal layer (4) and the electron affinity of the insulating layer (6). The work functions of graphene and Ti are 4.5 eV and 4.2 eV, respectively. Titanium thus fulfills the requirement that the first work function (3) has a larger value than the second work function (5). The electron affinity of TiO₂ is -4.0 eV. These values of work functions and electron affinity ensure the trapezoid shape of the tunneling barrier (7).

Fig. 4 displays the back gate dependence of the normalized resistance of the graphene channel before and after deposition of 25 nm of Ti on top. Such a back gate could be a metallic layer underneath the SiO₂ layer (11b). Fig. 4 displays a pronounced shift of the Dirac of the graphene from +5 to -40 V after deposition of the 25 nm Ti top electrode. This indicates an appreciable n-type doping of the graphene through the deposition of the Ti layer. This observation strongly supports the band alignment shown in fig. 2.

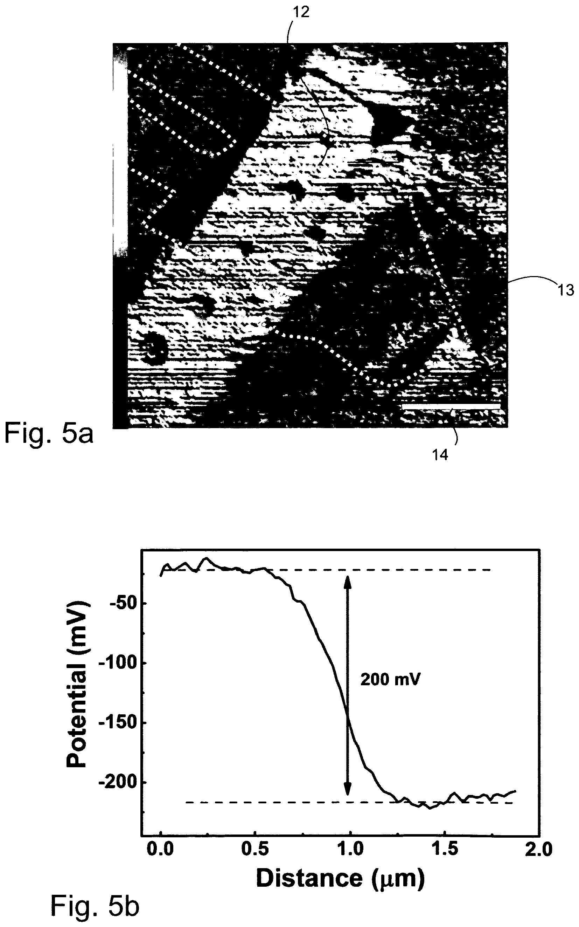

The work function difference between Ti and graphene is determined by Kelvin force microscopy. In fig. 5a a surface potential image of the electronic device (1) is shown. Further, 5b displays a section profile along the solid line (12) in the surface potential map in fig 5a. The dashed line (13) in the potential map marks the graphene sheet. The scale bar (14) is 2 µm. The detected potential difference of -200 meV is in reasonable agreement with the expected value of 0.3 eV. The somewhat smaller experimental value can be attributed to the n-doping of the graphene by the Ti. The n-doping of the graphene causes a reduction of the barrier height (8). In order to compensate this n-doping, the graphene layer (2) might be provided with a p-doping.

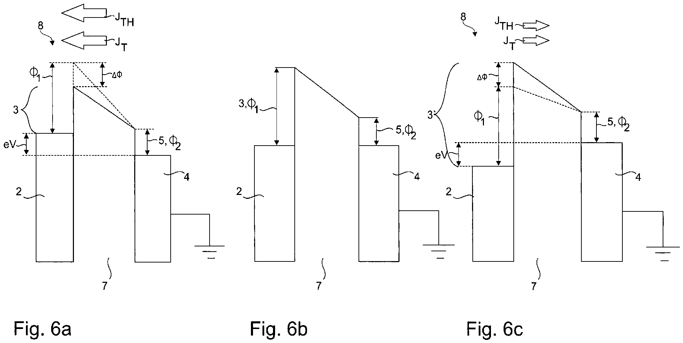

In fig. 6a, 6b, 6c the energy band diagram of the electronic device (1) is shown for different biases. Fig. 6b displays the energy band diagram at zero bias, fig. 6a shows the energy band diagram at negative bias and fig. 6c depicts the energy band diagram at positive bias. As already mentioned above, the energy band diagram is determined by the first work function (3) of the graphene layer (2), the second work function (5) of the metal layer (4) and the electron affinity of the insulating layer (6). The graphene (2) and the metal layers (4) are provided with ohmic contacts which form electrodes (9, 10) for the applied bias. The metal layer (4) is grounded and the potential is applied to the graphene layer (2).

The bias applied between the first (2) and the second electrically conductive layers (4) causes a carrier transport between the first (2) and the second electrically conductive layers (4) through said insulating layer (6). The carrier transport is electron transport which is dominated by transport based on a tunneling mechanism and based on thermionic emission. Thus, a thermionic current (J_{TH}) and a tunneling current (J_{T}) between the first (2) and the second electrically conductive layers (4) are the dominating currents.

In fig. 6c a positive bias is applied to the electronic device. In contrast to conventional MIM-diodes, where the barrier height is fixed, the barrier height (8) between the graphene layer (2) and the insulator layer (6) depends on the applied bias in the electronic device (1), caused by the modification of the first work function (3, Φ₁) of graphene under a bias. The first work function (Φ₁) of the graphene layer (2) increases by Δ_{Φ}, in case a positive bias is applied. The effective barrier height for the thermionic current (J_{TH}) depends on the increased first work function minus the applied potential (Φ₁+ Δ_{Φ}- eV). The thermionic current (J_{TH}) depends on the relative magnitude of eV and Δ_{Φ}. For sufficient thin insulating layers (6) which consist of a material with a very large dielectric constant, the condition eV < Δ_{Φ} may be achieved. In this case, the thermionic current (J_{TH}) would be fully blocked.

Further, the first work function Φ₁ of the graphene layer decreases by Δ_{Φ}, in case a negative bias is applied. This case is shown in Fig. 6c. The effective barrier height for the thermionic current (J_{TH}) depends on the increased first work function minus the applied potential (Φ₁- Δ_{Φ}).

In a conventional MIM-diode, the effective barrier height for the thermionic current is given by the first work function minus the applied potential (Φ₁-eV). For high biases, the effective barrier height reaches a minimum of Φ₂. In the negative bias regime, the barrier height for the thermionic current is Φ₁, independent of the magnitude of the bias. Therefore, the thermal current is forward when a positive bias is applied. With respect to the tunneling current, it is relevant that the slope of trapezoid potential decreases upon application of a positive bias, but increases when a negative bias is applied. Accordingly, the tunneling current is forward when a negative bias is applied.

In comparison to the conventional MIM-diode, the electronic device according to the present invention allows a higher thermionic current (J_{TH}) in forward direction. Forward direction here means that a preferably electron current flows from the ground potential of the second electrically conductive layer to the first electrically conductive layer, comprising graphene. Accordingly, an electron current backward direction would mean an electron current flow from the graphene layer (2) to the second electrically conductive layer (4) and to the ground potential.

Further, due to the bias-induced barrier height reduction, the tunneling current in the electronic device (1) of the present invention exceeds that in the MIM-structure, which renders
the former type of electronic device (1) more efficient.

Due to the increase of the thermionic current (J_{TH}) in forward direction and the reduction of the thermionic current (J_{TH}) in backward direction in the device of the present invention a high asymmetry (f*_{ASYM}* = I*_{forward}*/I*ᵣₑᵥₑᵣₛₑ)* and a strong nonlinearity (f*_{NL}* = (dl/dV) / (I/V)) are achieved. Further, a high on-current density consisting of the thermionic current and the tunneling current is achieved. In other words, as a major conceptual advantage over conventional MIM-diodes, the thermionic (J_{TH}) and tunneling currents (J_{T}) are simultaneously enhanced upon negatively biasing the graphene layer (2).

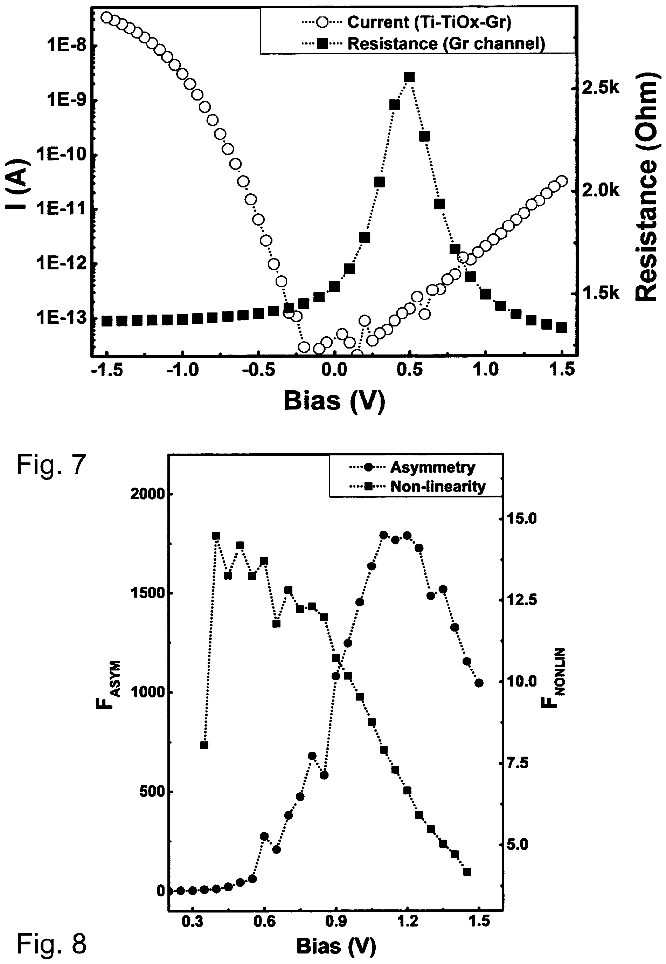

Fig. 7 shows the I-V characteristics and the dependence of the resistance of the graphene layer (2) on the bias. The I-V characteristics of the Gr-TiOx-Ti-diode (1), acquired between a four layer-thick graphene layer (2) and the metal layer (4), displays a diode-like behavior with a high current under negative bias and a low current under positive bias. The current comprising the thermionic (J_{TH}) and tunneling currents (J_{T}) flows from the graphene layer (2) to the metal layer (4) under a bias applied between the graphene (2) and the metal layer (4). Moreover, the resistance of the graphene layer (2) measured as a function of bias applied to the metal layer (4) signifies a change in the work function of the graphene layer, confirming the operation principle outlined above. In this measurement, a small bias of 0.01 V is applied to the graphene layer (2).

Fig. 8 displays the dependence of the asymmetry (f*_{ASYM}* = I*_{forward}*/I*ᵣₑᵥₑᵣₛₑ)* and nonlinearity (f*_{NL}* = (dl/dV) / (I/V)) on the bias. The plot reveals a maximum asymmetry of 1800 at 1.2 V and a corresponding nonlinearity of 7. The decrease of the asymmetry at higher bias is attributable to the rate of the Fermi level shift being dependent on the applied bias. Specifically, when the Fermi level is near the Dirac point, this rate is high due to the low density of states. By comparison, when the Fermi level moves away from the Dirac point, this rate decreases, such that the forward current saturates while the reverse current increases. An additional contribution to the saturation behavior may arise from trap states within the TiOₓ layer (6), as discussed below.
The operation mechanism devised in figures 6a, 6b, 6c suggests that the performance of the GrIM-diode (1) increases with the modulation rate of the barrier potential Δ_{Φ}(V) as a function of applied bias. Accordingly, the diode performance increases when the thickness of the graphene layer (2) and the insulating layer (6) are decreased.

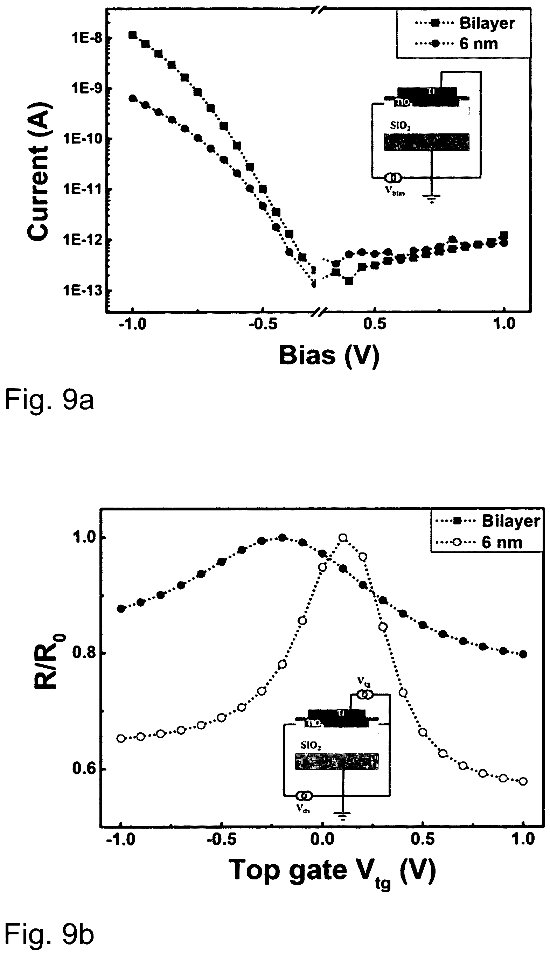

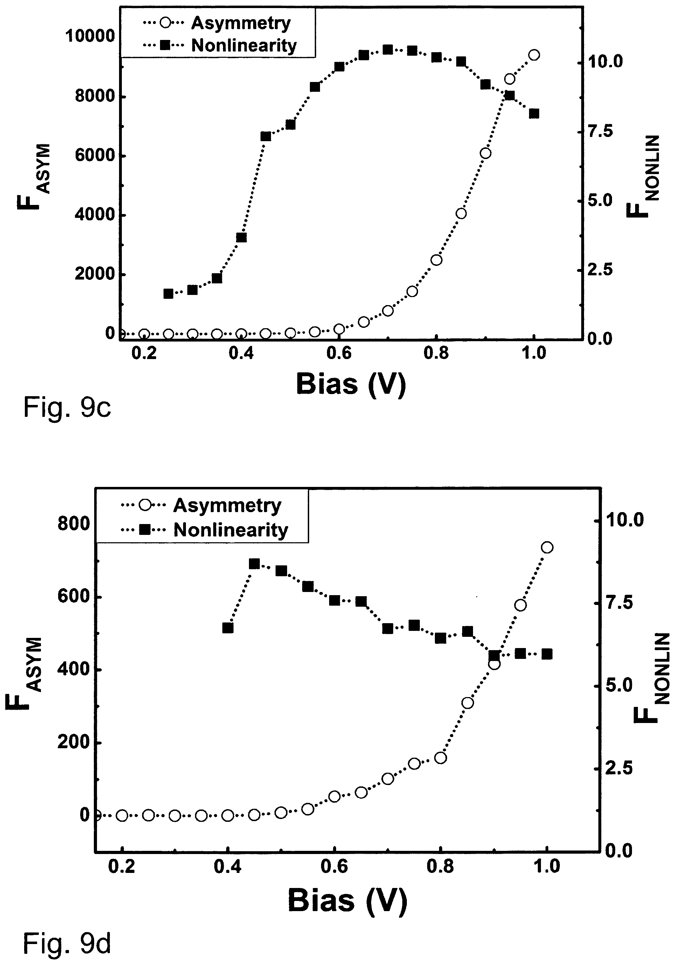

In figures 9a to 9c the electrical characteristics of the Gr-TiOx-Ti-diodes (1) in dependence of the thickness of the graphene layer are shown. All data were acquired at room temperature. In Fig. 9a the I-V characteristics of two different Gr-TiOx-Ti-diodes (1) comprising a graphene bilayer and a 6 nm thick graphene sheet, are displayed. In fig. 9b the normalized resistance of the graphene layer (2) as a function of the Ti electrodevoltage is depicted. In fig. 9c the dependence of the asymmetry and the nonlinearity on the bias voltage for a Gr-TiOx-Ti-diode (1), comprising a bilayer graphene layer (2) is plotted. In fig. 9d the dependence of the asymmetry and the nonlinearity on the bias voltage for Gr-TiOx-Ti diode (1), comprising the 6 nm thick graphene layer (2), is plotted.

The initial position of the Fermi level in graphene (due to external doping effects) affects the diode performance. In particular, for bilayer graphene devices with the Fermi level close to the Dirac point, an asymmetry of up to 9000 and a nonlinearity of 8 at 1 V are observed as shown in figure 9c. Based upon the lateral device size of 3x4 µm², the on-current density is estimated to be ∼0.1 A/cm². This value is comparable to those reported for the best MIM-diodes realized as Nb-Nb₂O₅-Pt₁₀ and much higher than for Nb-TiO₂-Pt diodes in which TiOₓ also serves as an insulator. In the GrIM-diode (1), the Ti electrode acts similarly like a top gate in field-effect transistor configuration.

Thus, it is possible to control the work function of graphene even if the sheet is relatively thick, as exemplified by a GrIM-diode (1) with a 6 nm thick graphene layer (see figure 9b). It is noteworthy that the diode performance also depends on the size of graphene area. Specifically, the performance decreases with decreasing the lateral size of the graphene sheet. This trend can be explained by an increasing influence of the Ti/Au contact, which in the smallest devices is likely to pin the Femi level of the graphene in the region below the TiOx/Ti layer.

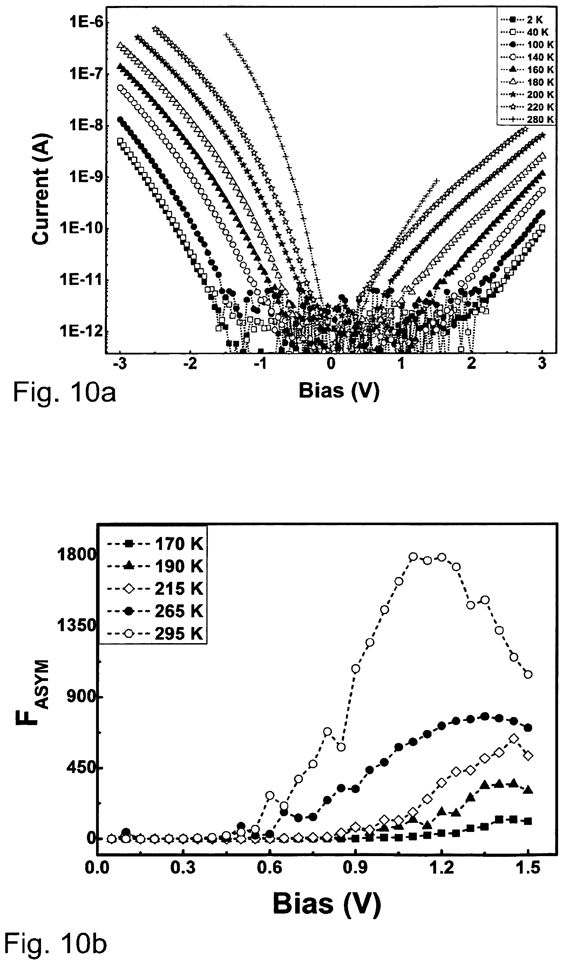

To clarify the charge transport mechanism, the temperature dependence of the I-V characteristics of the electronic device (1) is determined. Figures 10a and 10b display the effect of temperature on the Gr-TiOx-Ti-diode (1) performance. Fig. 10a depicts the I-V characteristics at different temperatures and fig. 10b the temperature dependence of the asymmetry. For both the positive and negative bias regime, the current decreases notably with decreasing temperature as shown in figure 10a. In fact, below 100 K, the current is less than 10-12 A at 1.5 V. This strong temperature activation demonstrates that tunneling is not the predominant transport mechanism within the bias window of ±1.5 V. As concluded from fits of the data charge transport in the positive bias regime rather occurs through thermionic emission and Poole-Frenkel tunneling (trap state-assisted tunneling). In the bias range from +1.3 to +1.5 V, the extracted barrier potential for the thermionic mechanism is 180 - 200 meV, while the barrier height associated with the Poole-Frenkel mechanism is 220 - 240 meV. It follows that the potential drop across the oxide layer is quite small even if a high bias is applied. In the negative bias regime, the experimental current cannot be fitted by either the thermionic emission or the Poole-Frenkel mechanism. Instead, it is plausible to assume that the barrier height becomes so small that the current passes directly through the TiOₓ layer via hoping through the trap state.

The temperature dependence of the diode asymmetry (f*_{ASYM})* exhibits a fast decrease upon cooling as displayed in fig. 10b. Typically, the asymmetry (f*_{ASYM})* should increase with decreasing temperature if the thermionic current is dominant ((∼exp((Φ₁-Φ₂)/k_{B}T)). A possible explanation for this discrepancy involves the presence of trap states inside the insulating (TiOₓ) layer (6), which limits the charge transport through the barrier. At room temperature, the on-current at high negative bias increases only slowly, while the off-current at high positive bias still exponentially increases with bias (Figure 10a). As a consequence, asymmetry f*_{ASYM}* first increases upon increasing the bias, then reaches a maximum at a voltage of -1.1 V, and finally decreases. The fact that the voltage position of the maximum shifts to higher bias upon cooling can be explained by the presence of trap states, due to which a higher bias must be applied to reach maximum current at lower temperatures. An opposite trend compared to f*_{ASYM}* is observed for f*_{NL}*, which increases upon cooling. Furthermore, in the plot of f*_{ASYM}* and f*_{NL}* (both at a bias of 1.2 V) as a function of inverse temperature, in each case two different exponential regimes can be discerned, indicative of two major types of current contributions. Taking the above observations together, the trap states emerge as the major factor that limits of the diode performance. Significant reduction of the trap density might be achievable by alternative methods of depositing the insulating (TiOₓ) layer (6), for instance with the aid of atomic layer deposition.

The high performance GrIM-diode (1) exhibits an operation principle that conceptually differs from conventional MIM diodes. The key mechanism involves the bias-induced modulation of the work function of the graphene layer, which in turn alters the transport barrier height. The Gr-TiOx-Ti diodes (1) reach a very high asymmetry and nonlinearity up to 9000 and 8, respectively, while maintaining a large on-current of 0.1 A/cm² at 1 V, rendering the devices competitive to state-of-the-art MIM diodes. Moreover, as a major conceptual advantage over conventional MIM-diodes, the thermionic (J_{TH}) and tunneling currents (J_{T}) are simultaneously enhanced upon negatively biasing the graphene layer.

### List of reference numerals

- 1: electronic device
- 2: first electrically conductive layer
- 3: first work function Φ₁
- 4: second electrically conductive layer
- 5: second work function Φ₂
- 6: insulating layer
- 7: tunneling barrier
- 8: barrier-height
- 9: electrode
- 10: electrode
- 11, 11a, 11b: substrate
- 12: line
- 13: line
- 14: scale bar
- J_{T}: tunneling current
- J_{TH}: thermionic current
- Δ_{Φ}: variation of first work function

## Claims

1. An electronic device (1) comprising:
- a first electrically conductive layer (2) provided with a first work function (3),
- a second electrically conductive layer (4) provided with a second work function (5), and
- an insulating layer (6) arranged between said first electrically conductive layer (2) and said second electrically conductive layer (4),
wherein a tunneling barrier (7) is formed between said first (2) and second electrically conductive layers (4) and a barrier-height (8) of the tunneling barrier (6) depends on said first (3) and second work functions (5), wherein the first electrically conductive layer (2) comprises graphene,
wherein the electronic device (1) is a diode and is configured so that a bias applied between the first (2) and the second electrically conductive layers (4) causes a carrier transport between the first (2) and the second electrically conductive layers (4) through said insulating layer (6) and modulates said first work function (3) and therefore said barrier-height (8) of the tunneling barrier (7), wherein the carrier transport is electron transport or hole transport and wherein the insulating layer (6) consists of an oxide,
the oxide being TiOₓ or ZnO or graphene-oxide in case of electron transport or the oxide being NiO or WO₃ in case of hole transport.

2. The electronic device (1) according to claim 1, **characterized in that** the carrier transport is modified due to the modulation of the height (8) of the tunneling barrier (7).

3. The electronic device (1) according to claim 1 or 2, **characterized in that** the carrier transport is dominated by a transport mechanism that is based on a tunneling and/or on thermionic emission.

4. The electronic device (1) according to any one of the preceding claims, **characterized in that** the first electrically conductive layer (2) consists of monolayer graphene or multilayer graphene.

5. The electronic device (1) according to any one of the preceding claims, **characterized in that** the first (2) and the second electrically conductive layers (4) are provided with ohmic contacts which form electrodes (9, 10) for the applied bias, wherein the second electrically conductive layer (4) is suitable for being grounded and the first electrically conductive layer (2) is suitable for receiving a potential.

6. The electronic device (1) according to any one of the preceding claims, **characterized in that** the first work function (3) has a larger value than the second work function (5).

7. The electronic device (1) according to any one of claims 1-5, **characterized in that** the second electrically conductive layer (4) consists of a metal, wherein the metal is chosen from Ti, Au, Cr, Ag , Ni or an alloy comprising Ti, Au, Cr, Ag, Ni if the carrier transport is electron transport, wherein the metal is Pd or Pt in case the carrier transport is hole transport.

8. The electronic device according to any one of the preceding claims, further comprising a substrate (11) on which the first electrically conductive (2) layer is deposited, wherein the substrate consists of a Si layer (11a) that is coated with a SiO₂-layer (11b) or wherein the substrate consists of a flexible material.

9. The electronic device according to any one of the preceding claims, **characterized in that** the first electrically conductive layer (2) consists of p-doped graphene.

10. The electronic device according to claim 4, **characterized in that** the graphene layer/s is/are exfoliated from highly oriented pyrolytic graphite (HOPG) or is/are produced by chemical vapor deposition.

11. The electronic device according to any one of the preceding claims, **characterized in that** the second electrically conductive layer (4) has a thickness in the range of 5 nm to 50 nm and/or the insulating layer (6) has a thickness in the range of 1 nm to 15 nm.

12. The electronic device (1) according to claim 4, **characterized in that** the first electrically conductive layer (2) consists of multilayer graphene of two or four layers.

13. The electronic device (1) according to claim 8, **characterized in that** the flexible material is a polymer.

## Patentansprüche

1. Elektronische Vorrichtung (1) umfassend:
- eine erste elektrisch leitende Schicht (2), welche mit einer ersten Austrittsarbeit (3) bereitgestellt ist,
- eine zweite elektrisch leitende Schicht (4), welche mit einer zweiten Austrittsarbeit (5) bereitgestellt ist, und
- eine isolierende Schicht (6), welche zwischen der ersten elektrisch leitenden Schicht (2) und der zweiten elektrisch leitenden Schicht (4) angeordnet ist,
wobei eine Tunnelbarriere (7) zwischen den ersten (2) und zweiten elektrisch leitenden Schichten (4) angeordnet ist und eine Barrierehöhe (8) der Tunnelbarriere (6) von den ersten (3) und zweiten Austrittsarbeiten (5) abhängt, wobei die erste elektrisch leitende Schicht (2) Graphen umfasst,
wobei die elektronische Vorrichtung (1) eine Diode ist und ausgebildet ist, dass eine Vorspannung, welche zwischen den ersten (2) und den zweiten elektrisch leitenden Schichten (4) angelegt ist, einen Ladungsträgertransport zwischen den ersten (2) und den zweiten elektrisch leitenden Schichten (4) durch die isolierende Schicht (6) verursacht und die erste Austrittsarbeit (3) und dementsprechend die Barrierehöhe (8) der Tunnelbarriere (7) moduliert, wobei der Ladungsträgertransport Elektrontransport oder Lochtransport ist und wobei die isolierende Schicht (6) aus einen Oxid besteht, wobei das Oxid TiOₓ oder ZnO oder Graphenoxid im Fall des Elektrontransports oder das Oxid NiO oder WO₃ im Fall des Lochtransports ist.

2. Elektronische Vorrichtung (1) nach Anspruch 1, **dadurch gekennzeichnet, dass** der Ladungsträgertransport aufgrund der Modulation der Höhe (8) der Tunnelbarriere (7) modifiziert ist.

3. Elektronische Vorrichtung (1) nach Anspruch 1 oder 2, **dadurch gekennzeichnet, dass** der Ladungsträgertransport durch einen Transportmechanismus dominiert ist, welcher auf einer Tunnel- und/oder thermionischen Emission basiert.

4. Elektronische Vorrichtung (1) nach einem der vorhergehenden Ansprüche, **dadurch gekennzeichnet, dass** die erste elektrisch leitende Schicht (2) aus Monoschicht-Graphen oder Multischicht-Graphen besteht.

5. Elektronische Vorrichtung (1) nach einem der vorhergehenden Ansprüche, **dadurch gekennzeichnet, dass** die ersten (2) und die zweiten elektrisch leitenden Schichten (4) mit ohmschen Kontakten bereitgestellt sind, welche Elektroden (9, 10) für die angelegte Vorspannung ausbilden, wobei die zweite elektrisch leitende Schicht (4) zum erden geeignet ist und die erste elektrisch leitende Schicht (2) zum Erhalten eines Potentials geeignet ist.

6. Elektronische Vorrichtung (1) nach einem der vorhergehenden Ansprüche, **dadurch gekennzeichnet, dass** die erste Austrittsarbeit (3) einen größeren Wert als die zweite Austrittsarbeit (5) aufweist.

7. Elektronische Vorrichtung (1) nach einem der Ansprüche 1-5, **dadurch gekennzeichnet ,dass** die zweite elektrisch leitende Schicht (4) aus einem Metall besteht, wobei das Metall ausgewählt ist aus Ti, Au, Cr, Ag, Ni oder einer Legierung umfassend Ti, Au, Cr, Ag, Ni, falls der Ladungsträgertransport Elektrontransport ist, wobei das Metall Pd oder Pt ist falls der Ladungsträgertransport Lochtransport ist.

8. Elektronische Vorrichtung nach einem der vorhergehenden Ansprüche, weiter umfassend ein Substrat (11), auf welchem die erste elektrisch leitende Schicht (2) aufgebracht ist, wobei das Substrat aus einer Si-Schicht (11a) besteht, welche mit einer SiO₂-Schicht (11b) beschichtet ist, oder wobei das Substrat aus einem flexiblen Material besteht.

9. Elektronische Vorrichtung nach einem der vorhergehenden Ansprüche, **dadurch gekennzeichnet, dass** die erste elektrisch leitende Schicht (2) aus p-dotierten Graphen besteht.

10. Elektronische Vorrichtung nach Anspruch 4, **dadurch gekennzeichnet, dass** die Graphenschicht/Graphenschichten sich von highly oriented pyrolytic graphite (HOPG) abschält/abschälen oder mittels chemischer Gasphasenabscheidung hergestellt sind.

11. Elektronische Vorrichtung nach einem der vorhergehenden Ansprüche, **dadurch gekennzeichnet, dass** die zweite elektrisch leitende Schicht (4) eine Dicke aus dem Bereich 5 nm bis 50 nm und/oder die isolierende Schicht (6) eine Dicke aus dem Bereich 1 nm bis 15 nm aufweist.

12. Elektronische Vorrichtung (1) nach Anspruch 4, **dadurch gekennzeichnet, dass** die erste elektrisch leitende Schicht (2) aus einem Multischicht-Graphen mit zwei oder vier Schichten besteht.

13. Elektronische Vorrichtung (1) nach Anspruch 8, **dadurch gekennzeichnet, dass** das flexible Material ein Polymer ist.

## Revendications

1. Dispositif électronique (1) comprenant:
- une première couche électroconductrice (2) munie d'une première fonction de travail (3),
- une seconde couche électroconductrice (4) munie d'une seconde fonction de travail (5), et
- une couche isolante (6) disposée entre ladite première couche électroconductrice (2) et ladite seconde couche électroconductrice (4),
une barrière de tunnellisation (7) étant formée entre lesdites première (2) et seconde (4) couches électroconductrices et une hauteur de barrière (8) de la barrière de tunnellisation (6) dépendant desdites première (3) et seconde (5) fonctions de travail, la première couche électroconductrice (2) comprenant du graphène,
le dispositif électronique (1) étant une diode et étant configuré de telle sorte qu'une polarisation appliquée entre les première (2) et seconde (4) couches électroconductrices entraîne un transport de porteurs entre les première (2) et seconde (4) couches électroconductrices à travers ladite couche isolante (6) et module ladite première fonction de travail (3) et, par conséquent, ladite hauteur de barrière (8) de la barrière de tunnellisation (7), le transport de porteurs étant un transport d'électrons ou un transport de trous, et la couche isolante (6) étant constituée d'un oxyde, l'oxyde étant un oxyde de graphène ou TiOₓ ou ZnO dans le cas d'un transport d'électrons ou l'oxyde étant NiO ou WO₃ dans le cas d'un transport de trous.

2. Dispositif électronique (1) selon la revendication 1, **caractérisé par le fait que** le transport de porteurs est modifié en raison de la modulation de la hauteur (8) de la barrière de tunnellisation (7).

3. Dispositif électronique (1) selon la revendication 1 ou 2, **caractérisé par le fait que** le transport de porteurs est dominé par un mécanisme de transport qui est basé sur une tunnellisation et/ou sur une émission thermionique.

4. Dispositif électronique (1) selon l'une quelconque des revendications précédentes, **caractérisé par le fait que** la première couche électroconductrice (2) est constituée de graphène monocouche ou de graphène multicouche.

5. Dispositif électronique (1) selon l'une quelconque des revendications précédentes, **caractérisé par le fait que** les première (2) et seconde (4) couches électroconductrices ont des contacts ohmiques qui forment des électrodes (9, 10) pour la polarisation appliquée, la seconde couche électroconductrice (4) étant appropriée pour être mise à la masse et la première couche électroconductrice (2) étant appropriée pour recevoir un potentiel.

6. Dispositif électronique (1) selon l'une quelconque des revendications précédentes, **caractérisé par le fait que** la première fonction de travail (3) a une valeur supérieure à la seconde fonction de travail (5).

7. Dispositif électronique (1) selon l'une quelconque des revendications 1 à 5, **caractérisé par le fait que** la seconde couche électroconductrice (4) est constituée d'un métal, le métal étant choisi parmi Ti, Au, Cr, Ag, Ni ou un alliage comprenant Ti, Au, Cr, Ag, Ni si le transport de porteurs est un transport d'électrons, le métal étant Pd ou Pt dans le cas où le transport de porteurs est un transport de trous.

8. Dispositif électronique (1) selon l'une quelconque des revendications précédentes, comprenant en outre un substrat (11) sur lequel la première couche électroconductrice (2) est déposée, le substrat étant constitué d'une couche de Si (11a) qui est revêtue d'une couche de SiO₂ (11b), ou le substrat étant constitué d'un matériau souple.

9. Dispositif électronique (1) selon l'une quelconque des revendications précédentes, **caractérisé par le fait que** la première couche électroconductrice (2) est constituée de graphène à dopage p.

10. Dispositif électronique (1) selon la revendication 4, **caractérisé par le fait que** la ou les couches de graphène est/sont exfoliées à partir de graphite pyrolytique fortement orienté (HOPG) ou est/sont produites par dépôt chimique en phase vapeur.

11. Dispositif électronique (1) selon l'une quelconque des revendications précédentes, **caractérisé par le fait que** la seconde couche électroconductrice (4) a une épaisseur comprise dans la plage allant de 5 nm à 50 nm et/ou la couche isolante (6) a une épaisseur comprise dans la plage allant de 1 nm à 15 nm.

12. Dispositif électronique (1) selon la revendication 4, **caractérisé par le fait que** la première couche électroconductrice (2) est constituée de graphène multicouche de deux ou quatre couches.

13. Dispositif électronique (1) selon la revendication 8, **caractérisé par le fait que** le matériau souple est un polymère.
